# EUROPÄISCHE PATENTSCHRIFT

(11) **EP 3 720 615 B1**
(45) Veröffentlichungstag und Bekanntmachung des Hinweises auf die Patenterteilung: **03.11.2021**
(21) Anmeldenummer: 19700347.8
(22) Anmeldetag: 08.01.2019
(51) Int. Cl.: B05C 11/10, B05C 5/02, F16K 1/00, F16K 31/00

(54) **VORRICHTUNG ZUM AUFTRAGEN EINES VISKOSEN MATERIALS AUF WERKSTÜCKE**
DEVICE FOR APPLYING A VISCOUS MATERIAL TO WORKPIECES
DISPOSITIF SERVANT À APPLIQUER UNE MATIÈRE VISQUEUSE SUR DES PIÈCES

(30) Priorität: 02.03.2018 DE 102018104835
(43) Veröffentlichungstag der Anmeldung: 14.10.2020
(73) Patentinhaber: Atlas Copco IAS GmbH, 75015 Bretten (DE)
(72) Erfinder: HAUSNER, Thomas, 75015 Bretten (DE); JÄGER, David, 76646 Bruchsal (DE); ENDERLE, Gerrit, 75438 Knittlingen (DE)
(74) Vertreter: Patentanwälte Bregenzer und Reule Partnerschaftsgesellschaft mbB
(86) Internationale Anmeldenummer: PCT/EP2019/050287
(87) Internationale Veröffentlichungsnummer: WO 2019/166139

(56) Entgegenhaltungen:
- DE-A1- 4 217 835
- DE-A1-102014 016 207
- DE-U1- 8 915 649
- DE-U1-202009 013 146

## Beschreibung

Die Erfindung betrifft eine Vorrichtung zum Auftragen eines viskosen Materials auf Werkstücke gemäß Oberbegriff des Anspruchs 1.

Solche Vorrichtungen dienen dem Auftragen von viskosem Material wie beispielsweise Klebstoff, Dichtstoff, Dämmstoff oder Wärmeleitpaste, auf ein Werkstück wie beispielsweise ein Karosserieteil in der Kraftfahrzeugfertigung. Je nach Anwendungsgebiet und Art des Materials kann es notwendig sein, durchgehende Materialraupen aufzutragen oder aber einzelne Materialpunkte, die im Abstand zueinander angeordnet sind. Beim Auftrag einzelner Materialpunkte besteht das Problem, dass ein Ventil der Auftragsvorrichtung beim Auftrag jedes Materialpunkts geöffnet und geschlossen werden muss. Bei einer schnellen zeitlichen Abfolge von Öffnungs- und Schließvorgängen ist der Einsatz von schnellschaltenden Ventilen erforderlich. Bei vorbekannten Auftragsvorrichtungen ist zu diesem Zweck jeweils eine Scheibe mit einer Öffnung vorgesehen, die hin und her gedreht wird, um den Auftragskanal im Wechsel freizugeben und wieder zu verschließen. Je schneller die Abfolge der aufgetragenen Materialpunkte sein soll, desto schneller muss die Scheibe zum Freigeben und wieder Verschließen des Auftragskanals beschleunigt und wieder abgebremst werden. Zu ihrem Antrieb sind dann leistungsfähige Motoren erforderlich, die einen hohen Energieverbrauch haben und groß bauen. Eine Vorrichtung der eingangs genannten Art ist aus der DE 42 17 835 A1 und der DE 20 2009 013 146 U1 bekannt. Diese Vorrichtungen weisen jeweils einen Spindeltrieb zur Betätigung der Ventilnadel auf, dessen Spindel zum Öffnen und Schließen der Nadelventile in unterschiedliche Richtungen gedreht werden muss. Aus der US 6,514,569 B1 ist ein Betätigungselement mit einer umlaufenden Führungsnut bekannt, das dazu dient, den Förderzylinder einer Pumpe zu bewegen.

Es ist daher Aufgabe der Erfindung, eine Vorrichtung der eingangs genannten Art derart weiterzubilden, dass der Auftrag von Materialpunkten verbessert wird. Diese Aufgabe wird erfindungsgemäß durch eine Vorrichtung mit den Merkmalen des Anspruchs 1 gelöst. Vorteilhafte Weiterbildungen der Erfindung sind Gegenstand der abhängigen Ansprüche.

Der Erfindung liegt der Gedanke zugrunde, dass das Betätigungselement mit hoher Geschwindigkeit gedreht werden kann und sich die Ventilnadel durch diese Drehung um die gehäusefeste Drehachse aufgrund des Eingriffs des mindestens einen Zapfens in die Führungsnut und aufgrund der Verbindung mit dem mindestens einen Zapfen oder dem Betätigungselement in axialer Richtung hin und her bewegt. Die Führungsnut läuft rings um die Mantelfläche des Betätigungselements um und ist in sich geschlossen, so dass die Ventilnadel nach einer Drehung des Betätigungselements um 360 Grad stets wieder in ihre Ausgangslage bezüglich des Gehäuses zurückkehrt und dabei den Zuführkanal stetig im Wechsel freigibt und wieder verschließt. Dabei ist es möglich, dass das Betätigungselement in der Längsrichtung unverschieblich im Gehäuse gelagert ist und dass der mindestens eine Zapfen fest mit der Ventilnadel verbunden und in der Längsrichtung verschieblich im Gehäuse gelagert ist, oder aber dass der mindestens eine Zapfen gehäusefest ist und dass die Ventilnadel fest mit dem Betätigungselement verbunden ist. Ein ständiges Beschleunigen und Abbremsen des Betätigungselements ist dabei in der Regel nicht erforderlich. Das energieintensive Beschleunigen und Abbremsen eines Schließkörpers wie bei vorbekannten Vorrichtungen, das eine hohe Motorleistung erfordert, entfällt dabei weitgehend. Die Zahl der pro Zeiteinheit abgegebenen Materialpunkte lässt sich zudem auf einfache Weise durch Änderung der Drehzahl steuern. Die Verwendung eines weniger leistungsfähigen Motors, der kleiner baut, verringert zudem den Platzbedarf. Zudem ist es möglich, durch definiertes Verdrehen des Betätigungselements die Austrittsöffnung in definierter Weise zu öffnen, um den Materialfluss zu regeln. Insbesondere können auch Materialraupen aufgetragen werden, wobei durch die Stellung des Betätigungselements im Gehäuse die Dicke der Materialraupe definiert wird.

Zweckmäßig sind mindestens zwei Zapfen vorgesehen, die in die Führungsnut eingreifen, und die vorzugsweise in gleichen Winkelabständen zueinander angeordnet sind. Diese Maßnahme sorgt für eine stabilere Führung des Betätigungselements im Gehäuse. Dabei ist es möglich, dass die Führungsnut eine erste, in einer ersten Richtung gekrümmte Partie sowie eine sich an die erste Partie anschließende zweite, in einer in entgegengesetzter Richtung gekrümmte Partie aufweist, so dass bei einer Drehung des Betätigungselements im Gehäuse um 360° dieses genau einmal hin und wieder her bewegt wird. Um die Öffnungs- und Schließfrequenz des Nadelventils zu erhöhen ohne hierfür die Drehzahl des Betätigungselements im Gehäuse erhöhen zu müssen, kann vorteilhaft vorgesehen sein, dass die Führungsnut mehrere aneinander anschließende identische Abschnitte aufweist. Jeder dieser Abschnitte weist dann eine erste Partie mit einer Krümmung in die erste Richtung und eine sich daran anschließende zweite Partie mit einer Krümmung in die entgegengesetzte zweite Richtung auf, so dass das Betätigungselement bei einer Drehung um 360° im Gehäuse mehrere Hin- und Herbewegungen im Gehäuse ausführt und das Nadelventil mehrfach öffnet und schließt. Die ersten und zweiten Partien sind zweckmäßig jeweils gleich lang.

Die erfindungsgemäße Vorrichtung weist zweckmäßig einen Motor zum Drehen des Betätigungselements auf, welcher vorteilhaft als Elektromotor und insbesondere als Servomotor ausgebildet ist. Desweiteren wird bevorzugt, dass der Motor lösbar am Gehäuse befestigt ist, so dass er auf einfache Weise ausgetauscht werden kann. Vorteilhaft treibt der Motor ein Antriebselement an, das mittels Reib- oder Formschluss mit dem Betätigungselement verbunden ist. Zusätzlich kann es mittels einer vorzugsweise lösbaren Verbindung am Betätigungselement fixiert sein. Bei einer losen Verbindung zwischen dem Antriebselement und dem Betätigungselement muss das Antriebselement nicht aufwendig vom Betätigungselement gelöst werden, wenn es zusammen mit dem Motor ausgetauscht werden soll. Zweckmäßig weist das Betätigungselement dann an einer dem Ventilsitz abgewandten Stirnfläche eine Eingriffskontur auf, in die das Antriebselement eingreift. Die Eingriffskontur hat vorzugsweise die Form eines Kreuzschlitzes, während das Antriebselement eine hierzu komplementäre Form aufweist.

Mit der erfindungsgemäßen Vorrichtung kann ein Verfahren zum Auftragen eines viskosen Materials auf Werkstücke ausgeführt werden. Dabei wird das viskose Material druckbeaufschlagt in den Auftragskanal eingeleitet und das Nadelventil wird mittels Drehen des Betätigungselements im Gehäuse durch Abheben der Ventilnadel vom Ventilsitz und Aufsetzen der Ventilnadel auf den Ventilsitz periodisch geöffnet und geschlossen. Die Frequenz, mit der Materialpunkte abgegeben werden, kann auf diese Weise einfach durch Änderung der Drehzahl des Betätigungselements variiert werden. Bei einem alternativen Auftragsverfahren wird durch ein gezieltes Verdrehen des Betätigungselements bezüglich des Gehäuses und eine daraus resultierende Linearbewegung der Ventilnadel ein definierter Materialfluss durch die Austrittsöffung eingestellt.

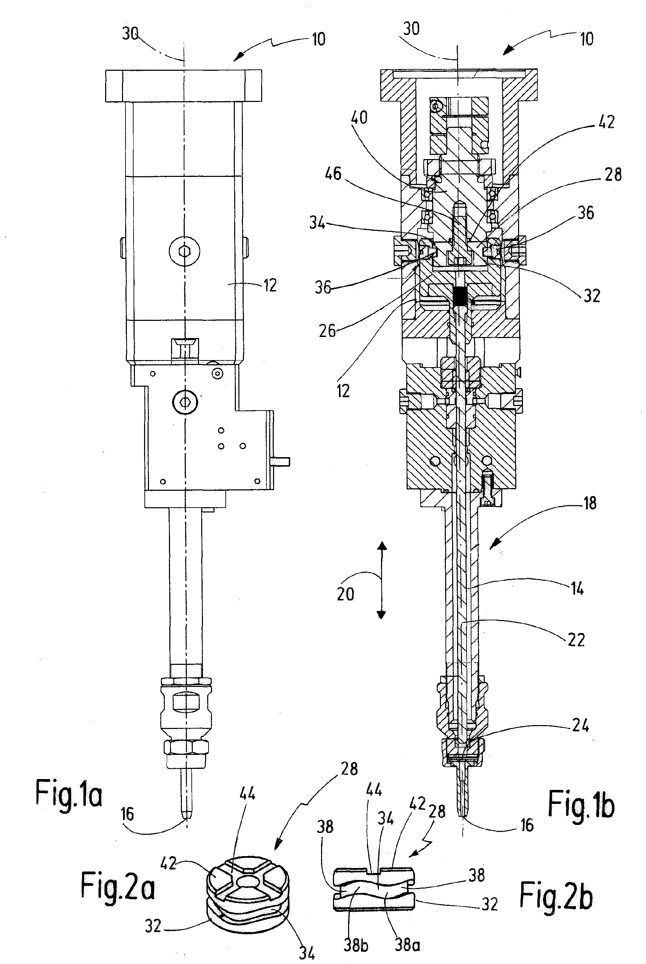

Im Folgenden wird die Erfindung anhand eines in der Zeichnung schematisch dargestellten Ausführungsbeispiels näher erläutert. Es zeigen
- Fig. 1a: eine Vorrichtung zum Auftragen eines viskosen Materials in Seiten-ansicht;
- Fig. 1b: die Vorrichtung gemäß Fig. 1a in einer Schnittdarstellung entlang der Linie A-A und
- Fig. 2a, 2b: eine Betätigungselement in perspektivischer Ansicht und in Seiten-ansicht.

Die in der Zeichnung dargestellte Vorrichtung 10 dient dem Auftragen von viskosem Material wie Klebstoff, Dichtstoff, Dämmstoff oder Wärmeleitpaste, auf Werkstücke. Sie weist ein Gehäuse 12 auf, durch das ein Auftragskanal 14 bis zu einer Austrittsöffnung 16 verläuft, über den das viskose Material zum Auftrag auf das Werkstück geleitet wird. Im Gehäuse 12 ist ein Nadelventil 18 angeordnet, das eine in einer Längsrichtung 20 verschiebliche und sich in der Längsrichtung 20 erstreckende Ventilnadel 22 aufweist, die zum Verschließen des Auftragskanals 14 auf einen Ventilsitz 24 aufgesetzt und zum Freigeben des Auftragskanals 14 vom Ventilsitz 24 abgehoben wird.

Die Ventilnadel 22 ist fest mit einer nach oben offenen, in der Längsrichtung begrenzt im Gehäuse verschieblichen Hülse 26 verbunden, in der ein Betätigungselement 28 aufgenommen ist. Das Betätigungselement 28 ist im Gehäuse 12 um eine sich parallel zur Längsrichtung 20 erstreckende Drehachse 30 drehbar und in der Längsrichtung 20 bezüglich des Gehäuses 12 unverschieblich angeordnet. Es weist eine radiale Mantelfläche 32 auf, in der eine rings umlaufende Führungsnut 34 angeordnet ist, in die zwei einander diametral gegenüberliegende, fest mit der Hülse 26 verbundene und sich in radialer Richtung nach innen erstreckende Zapfen 36 eingreifen. Die Führungsnut 34 ist in sich geschlossen und in axialer Richtung 20 gekrümmt, so dass eine Drehung des Betätigungselements 28 bezüglich des Gehäuses 12 in einer linearen Bewegung der Zapfen 36, der Hülse 26 und der Ventilnadel 22 zwischen zwei Endpositionen resultiert. Dabei weist die Führungsnut 34 zwei identische Abschnitte 38 auf, die sich jeweils über die Hälfte des Umfangs der Mantelfläche 32 erstrecken und ineinander übergehen. Jeder der Abschnitte 38 weist eine in Drehrichtung betrachtet nach unten zum Ventilsitz 24 geneigte erste Partie 38a und eine an die erste Partie 38a anschließende, in Drehrichtung betrachtet nach oben vom Ventilsitz 24 weg geneigte zweite Partie 38b auf. Wird das Betätigungselement 28 um 180° um die Drehachse 30 gedreht, so gelangt die Ventilnadel 22 wieder in ihre Ausgangsposition. Um das Nadelventil 18 einmal zu öffnen und wieder zu schließen, genügt es daher, das Betätigungselement 28 um 180° zu drehen, welches dann seine Drehbewegung in eine Linearbewegung der Hülse und der Ventilnadel 22 im Gehäuse 12 umsetzt.

Zur Drehung des Betätigungselements 28 ist ein als Servomotor ausgebildeter Elektromotor vorgesehen, der in der Zeichnung nicht dargestellt ist. Der Servomotor treibt ein im Gehäuse 12 angeordnetes Antriebselement 40 an, das wiederum auf einer der Stirnfläche 26 abgewandten Stirnfläche 42 des Betätigungselements 28 aufliegt. In der Stirnfläche 42 befindet sich eine Eingriffskontur 44 in Form eines Kreuzschlitzes, in die eine komplementäre Kontur des Antriebselements 40 formschlüssig eingreift. Das Antriebselement 40 kann fest mit dem Servomotor verbunden sein und zusammen mit diesem vom Betätigungselement 28 abgehoben und aus dem Gehäuse 12 entnommen werden. Es ist zudem mittels einer Schraube 46 lösbar mit dem Betätigungselement 28 verbunden.

Die Auftragsvorrichtung 10 kann insbesondere in zwei Betriebsarten betrieben werden, wobei das viskose Material druckbeaufschlagt in den Auftragskanal eingeleitet wird. Zum einen können Punkte des Materials in schneller Abfolge auf ein Werkstück aufgetragen werden, indem das Betätigungselement 28 im Gehäuse 12 gedreht wird. Die Auftragsfrequenz kann durch Regeln der Drehfrequenz des Betätigungselements 28 geregelt werden. Zum anderen kann durch gezieltes Verdrehen des Betätigungselements 28 bezüglich des Gehäuses 12 ein definierter Materialfluss durch die Austrittsöffnung 16 eingestellt werden.

Alternativ zum oben beschriebenen Ausführungsbeispiel, bei dem die Ventilnadel 22 über die Hülse 26 fest mit den im Gehäuse linear beweglichen Zapfen 36 verbunden ist, kann die Ventilnadel 22 auch fest mit dem Betätigungselement 28 verbunden sein. Die Zapfen 36 sind dann gehäusefest, und die Drehung des Betätigungselements 28 um die Drehachse 30 bewirkt dann eine lineare Hin- und Herbewegung des Betätigungselements 28 im Gehäuse unter Mitnahme der Ventilnadel 22.

Zusammenfassend ist folgendes festzuhalten: Die Erfindung betrifft eine Vorrichtung 10 zum Auftragen eines viskosen Materials auf Werkstücke mit einem Gehäuse 12, mit einem im Gehäuse 12 bis zu einer Austrittsöffnung 16 verlaufenden Auftragskanal 14 und mit einem Nadelventil 18 zum Freigeben und Schließen des Auftragskanals 14 an einem Ventilsitz 24. Erfindungsgemäß ist vorgesehen, dass im Gehäuse 12 ein Betätigungselement 28 um eine Drehachse 30 drehbar gelagert ist, wobei sich die Drehachse 30 parallel zu einer Längsrichtung 20 erstreckt, in der die Ventilnadel 22 des Nadelventils 18 bezüglich des Gehäuses 12 verschieblich ist, dass das Betätigungselement 28 in seiner radialen Mantelfläche 32 eine rings umlaufende, in axialer Richtung 20 gekrümmte Führungsnut 34 aufweist, in die mindestens ein sich in radialer Richtung erstreckender Zapfen 36 eingreift, und dass die Ventilnadel 22 so mit dem Betätigungselement 28 oder dem mindestens einen Zapfen 36 verbunden ist, dass eine Drehung des Betätigungselements 28 um die Drehachse 30 eine Verschiebung der Ventilnadel 22 bezüglich des Gehäuses 12 in der Längsrichtung 20 bewirkt.

## Patentansprüche

1. Vorrichtung zum Auftragen eines viskosen Materials auf Werkstücke mit einem Gehäuse (12), mit einem im Gehäuse (12) bis zu einer Austrittsöffnung (16) verlaufenden Auftragskanal (14) und mit einem Nadelventil (18) zum Freigeben und Schließen des Auftragskanals (14) an einem Ventilsitz (24), wobei im Gehäuse (12) ein Betätigungselement (28) um eine Drehachse (30) drehbar gelagert ist, wobei sich die Drehachse (30) parallel zu einer Längsrichtung (20) erstreckt, in der die Ventilnadel (22) des Nadelventils (18) bezüglich des Gehäuses (12) verschieblich ist, wobei das Betätigungselement (28) in seiner radialen Mantelfläche (32) eine rings umlaufende und in axialer Richtung (20) gekrümmte Führungsnut (34) aufweist, in die mindestens ein sich in radialer Richtung erstreckender Zapfen (36) eingreift, und wobei die Ventilnadel (22) so mit dem Betätigungselement (28) oder dem mindestens einen Zapfen (36) verbunden ist, dass eine Drehung des Betätigungselements (28) um die Drehachse (30) eine Verschiebung der Ventilnadel (22) bezüglich des Gehäuses (12) in der Längsrichtung (20) bewirkt, **dadurch gekennzeichnet, dass** die Führungsnut (34) in sich geschlossen ist.

2. Vorrichtung nach Anspruch 1, **dadurch gekennzeichnet, dass** das Betätigungselement (28) in der Längsrichtung (20) unverschieblich im Gehäuse (12) gelagert ist und dass der mindestens eine Zapfen (36) fest mit der Ventilnadel (22) verbunden und in der Längsrichtung (20) verschieblich im Gehäuse (12) gelagert ist.

3. Vorrichtung nach Anspruch 1 oder 2, **dadurch gekennzeichnet, dass** der mindestens eine Zapfen (36) gehäusefest ist und dass die Ventilnadel (22) fest mit dem Betätigungselement (28) verbunden ist.

4. Vorrichtung nach einem der vorangehenden Ansprüche, **dadurch gekennzeichnet, dass** mindestens zwei vorzugsweise in gleichen Winkelabständen zueinander angeordnete Zapfen (36) in die Führungsnut (34) eingreifen.

5. Vorrichtung nach einem der vorangehenden Ansprüche, **dadurch gekennzeichnet, dass** die Führungsnut (34) mehrere aneinander anschließende identische Abschnitte (38) aufweist.

6. Vorrichtung nach einem der vorangehenden Ansprüche, **gekennzeichnet durch** einen Motor zum Drehen des Betätigungselements (28).

7. Vorrichtung nach Anspruch 6, **dadurch gekennzeichnet, dass** der Motor ein Elektromotor, insbesondere ein Servomotor, ist.

8. Vorrichtung nach Anspruch 6 oder 7, **dadurch gekennzeichnet, dass** der Motor lösbar am Gehäuse (12) befestigt ist.

9. Vorrichtung nach einem der Ansprüche 6 bis 8, **dadurch gekennzeichnet, dass** der Motor ein Antriebselement (40) antreibt, das mittels Reib- oder Formschluss mit dem Betätigungselement (28) verbunden ist.

10. Vorrichtung nach Anspruch 9, **dadurch gekennzeichnet, dass** das Betätigungselement (28) an einer dem Ventilsitz (24) abgewandten Stirnfläche (42) eine Eingriffskontur (44) aufweist, in die das Antriebselement (40) eingreift.

11. Vorrichtung nach Anspruch 10, **dadurch gekennzeichnet, dass** die Eingriffskontur (44) die Form eines Kreuzschlitzes hat.

12. Verfahren zum Auftragen eines viskosen Materials auf Werkstücke unter Verwendung einer Vorrichtung (10) nach einem der vorangehenden Ansprüche, wobei das viskose Material druckbeaufschlagt in den Auftragskanal (14) eingeleitet wird und wobei mittels Drehen des Betätigungselements (28) im Gehäuse (12) das Nadelventil (18) durch Abheben der Ventilnadel (22) vom Ventilsitz (24) und Aufsetzen der Ventilnadel (22) auf den Ventilsitz (24) periodisch geöffnet und geschlossen wird.

13. Verfahren zum Auftragen eines viskosen Materials auf Werkstücke unter Verwendung einer Vorrichtung (10) nach einem der Ansprüche 1 bis 11, wobei das viskose Material druckbeaufschlagt in den Auftragskanal (14) eingeleitet wird und wobei ein Materialfluss durch die Austrittsöffnung (16) mittels Verdrehen des Betätigungselements (28) bezüglich des Gehäuses (12) geregelt wird.

## Claims

1. Device for application of a viscous material to workpieces, having a housing (12), having an application channel (14) that runs in the housing (12) all the way to an exit opening (16), and having a needle valve (18) for releasing and closing the application channel (14) at a valve seat (24), wherein an actuation element (28) is mounted in the housing (12) so as to rotate about an axis of rotation (30), wherein the axis of rotation (30) extends parallel to a longitudinal direction (20), in which the valve needle (22) of the needle valve (18) can be displaced with reference to the housing (12), that the actuation element (28) has a guide groove (34) in its radial mantle surface (32), which groove runs all the way around and is curved in the axial direction (20), into which groove at least one pin (36) that extends in the radial direction engages, and wherein the valve needle (22) is connected with the actuation element (28) or with the at least one pin (36) in such a manner that a rotation of the actuation element (28) about the axis of rotation (30) brings about a displacement of the valve needle (22) with reference to the housing (12), in the longitudinal direction (20), **characterized in that** the guide groove (34) is closed in itself.

2. Device according to claim 1, **characterized in that** the actuation element (28) is mounted in the housing (12) so as to be non-displaceable in the longitudinal direction (20), and that the at least one pin (36) is firmly connected with the valve needle (22) and is mounted so as to be displaceable in the housing (12) in the longitudinal direction (20).

3. Device according to claim 1 or 2, **characterized in that** the at least one pin (36) is fixed in place on the housing and that the valve needle (22) is firmly connected with the actuation element (28).

4. Device according to one of the preceding claims, **characterized in that** at least two pins (36) are provided, which engage into the guide groove (34), and which are preferably arranged at equal angle distances from one another.

5. Device according to one of the preceding claims, **characterized in that** the guide groove (34) has multiple identical sections (38) that follow one another.

6. Device according to one of the preceding claims, **characterized by** a motor for rotation of the actuation element (28).

7. Device according to claim 6, **characterized in that** the motor is an electric motor, in particular a servomotor.

8. Device according to claim 6 or 7, **characterized in that** the motor is releasably fastened onto the housing (12).

9. Device according to one of claims 6 to 8, **characterized in that** the motor drives a drive element (40) that is connected with the actuation element (28) by means of friction fit or shape fit.

10. Device according to claim 9, **characterized in that** the actuation element (28) has an engagement contour (44) at the end-face surface (42) that faces away from the valve seat (24), into which contour the drive element (40) engages.

11. Device according to claim 10, **characterized in that** the engagement contour (44) has the shape of a cross-slot.

12. Method for application of a viscous material to workpieces, using a device (10) according to one of the preceding claims, wherein the viscous material is introduced into the application channel (14) under the effect of pressure, and wherein the needle valve (18) is periodically opened and closed by means of rotation of the actuation element (28) in the housing (12), by lifting the valve needle (22) off the valve seat (24) and setting the valve needle (22) onto the valve seat (24).

13. Method for application of a viscous material to workpieces, using a device (10) according to one of claims 1 to 11, wherein the viscous material is introduced into the application channel (14) under the effect of pressure, and wherein a material flow through the exit opening (16) is regulated by means of rotation of the actuation element (28) with reference to the housing (12).

## Revendications

1. Dispositif conçu pour appliquer une matière visqueuse sur des pièces, comprenant un boîtier (12), un canal d'application (14) parcourant ledit boîtier (12) jusqu'à un orifice de sortie (16), et une soupape (18) à pointeau, affectée au dégagement et à l'obturation dudit canal d'application (14) au niveau d'un siège d'obturation (24), sachant qu'un élément d'actionnement (28) est monté rotatif autour d'un axe de rotation (30), dans le boîtier (12), lequel axe de rotation (30) s'étend parallèlement à une direction longitudinale (20) dans laquelle le pointeau (22) de ladite soupape (18) est apte à coulisser par rapport audit boîtier (12), l'élément d'actionnement (28) étant pourvu, dans la surface radiale (32) de son enveloppe, d'une rainure de guidage (34) s'étendant circonférentiellement, curviligne dans la direction axiale (20), et dans laquelle pénètre au moins une cheville (36) s'étendant dans la direction radiale, sachant que le pointeau (22) de la soupape est relié à l'élément d'actionnement (28), ou à la cheville (36) à présence minimale, de façon telle qu'une rotation dudit élément d'actionnement (28), autour de l'axe de rotation (30), provoque un coulissement dudit pointeau (22) de la soupape dans la direction longitudinale (20) par rapport au boîtier (12), **caractérisé par le fait que** la rainure de guidage (34) est par elle-même fermée.

2. Dispositif selon la revendication 1, **caractérisé par le fait que** l'élément d'actionnement (28) est monté, dans le boîtier (12), sans faculté de coulissement dans la direction longitudinale (20) ; et **par le fait que** la cheville (36) à présence minimale est reliée rigidement au pointeau (22) de la soupape et est montée, dans ledit boîtier (12), avec faculté de coulissement dans ladite direction longitudinale (20).

3. Dispositif selon la revendication 1 ou 2, **caractérisé par le fait que** la cheville (36) à présence minimale fait corps avec le boîtier (12) ; et **par le fait que** le pointeau (22) de la soupape est relié rigidement à l'élément d'actionnement (28).

4. Dispositif selon l'une des revendications précédentes, **caractérisé par le fait qu'**au moins deux chevilles (36) préférentiellement situées à des espacements angulaires égaux, l'une par rapport à l'autre, pénètrent dans la rainure de guidage (34).

5. Dispositif selon l'une des revendications précédentes, **caractérisé par le fait que** la rainure de guidage (34) comporte plusieurs tronçons identiques (38) mutuellement attenants.

6. Dispositif selon l'une des revendications précédentes, **caractérisé par** un moteur conçu pour faire tourner l'élément d'actionnement (28).

7. Dispositif selon la revendication 6, **caractérisé par le fait que** le moteur est un moteur électrique, un servomoteur en particulier.

8. Dispositif selon la revendication 6 ou 7, **caractérisé par le fait que** le moteur est fixé au boîtier (12) de manière libérable.

9. Dispositif selon l'une des revendications 6 à 8, **caractérisé par le fait que** le moteur mène un élément d'entraînement (40) relié à l'élément d'actionnement (28) en coopérant par friction, ou par complémentarité de formes.

10. Dispositif selon la revendication 9, **caractérisé par le fait que** l'élément d'actionnement (28) est muni, sur une face extrême (42) pointant à l'opposé du siège d'obturation (24), d'un profil (44) de venue en prise dans lequel l'élément d'entraînement (40) pénètre.

11. Dispositif selon la revendication 10, **caractérisé par le fait que** le profil (44) de venue en prise se présente comme une fente cruciforme.

12. Procédé d'application d'une matière visqueuse sur des pièces, avec utilisation d'un dispositif (10) conforme à l'une des revendications précédentes, sachant que ladite matière visqueuse est introduite dans le canal d'application (14) en étant sollicitée par une pression et sachant que, sous l'effet d'une rotation de l'élément d'actionnement (28) dans le boîtier (12), la soupape (18) à pointeau est ouverte et fermée périodiquement par soulèvement du pointeau (22) de ladite soupape à l'écart du siège d'obturation (24), et par venue en applique dudit pointeau (22) de la soupape sur ledit siège d'obturation (24).

13. Procédé d'application d'une matière visqueuse sur des pièces, avec utilisation d'un dispositif (10) conforme à l'une des revendications 1 à 11, sachant que ladite matière visqueuse est introduite dans le canal d'application (14) en étant sollicitée par une pression et sachant qu'un flux de matière, empruntant l'orifice de sortie (16), est régulé sous l'effet d'une rotation de l'élément d'actionnement (28) par rapport au boîtier (12).
